# EUROPÄISCHE PATENTSCHRIFT

(11) **EP 4 277 066 B1**
(45) Veröffentlichungstag und Bekanntmachung des Hinweises auf die Patenterteilung: **25.09.2024**
(21) Anmeldenummer: 23169242.7
(22) Anmeldetag: 21.04.2023
(51) Int. Cl.: H01H 47/00, H02H 11/00, H02H 3/05, H02H 3/04

(54) **SICHERHEITSSCHALTVORRICHTUNG INSBESONDERE ZUM ÜBERWACHTEN EINSCHALTEN EINES ELEKTRISCHEN UND/ODER ELEKTRONISCHEN VERBRAUCHERS**
SAFETY SWITCHING DEVICE, IN PARTICULAR FOR MONITORED SWITCHING ON OF AN ELECTRICAL AND/OR ELECTRONIC CONSUMER
DISPOSITIF DE COMMUTATION DE SÉCURITÉ, EN PARTICULIER POUR LA MISE SOUS TENSION CONTRÔLÉE D'UN CONSOMMATEUR ÉLECTRIQUE ET/OU ÉLECTRONIQUE

(30) Priorität: 03.05.2022 DE 102022110812
(43) Veröffentlichungstag der Anmeldung: 15.11.2023
(73) Patentinhaber: PHOENIX CONTACT GMBH & CO. KG, 32825 Blomberg (DE)
(72) Erfinder: PETER, Henry, 37574 Einbeck (DE); FRANKE, Felix, 31812 Bad Pyrmont (DE)
(74) Vertreter: Blumbach · Zinngrebe Patentanwälte PartG mbB

(56) Entgegenhaltungen:
- DD-A1- 254 074
- DE-A1- 19 913 933
- US-A1- 2020 096 571

## Beschreibung

Die Erfindung betrifft eine Sicherheitsschaltvorrichtung insbesondere zum überwachten Einschalten bzw. Anschalten eines elektrischen und/oder elektronischen Verbrauchers an eine Versorgungsspannung. Die Sicherheitsschaltvorrichtung kann bevorzugt in industriellen automatisierten Prozesssteuerungssystemen eingesetzt werden.

Sicherheitsschaltvorrichtungen dienen insbesondere dazu, elektrische und/oder elektronische Verbraucher bei Auftritt eines Fehlers entweder in einen sicheren Zustand zu fahren oder vollständig abzuschalten, um Bedienungspersonal vor Verletzungen und Gesundheitsschäden zu schützen und eine Beschädigung oder Zerstörung von Geräten zu verhindern. Um einen sicheren Betrieb einer Sicherheitsschaltvorrichtung gewährleisten zu können, sind solche Sicherheitsschaltvorrichtungen beispielsweise redundant aufgebaut, indem zum Beispiel zwei Schaltelemente in Reihe zueinander in wenigstens einen Laststrompfad geschaltet sind. Nur wenn der Laststrompfad durch beide Schaltelemente geschlossen wird, kann ein elektrischer und/oder elektronischer Verbraucher eingeschaltet bzw. an eine Versorgungsspannung angeschlossen werden. Üblicherweise können ein- oder mehrphasige Verbraucher über eine Sicherheitsschaltvorrichtung an eine ein- oder mehrphasige Versorgungsspannung angeschlossen werden. Um den ordnungsgemäßen Betrieb sicherstellen zu können, müssen insbesondere die Schaltelemente auf ihre Funktionsfähigkeit hin überwacht werden. Bekannt ist, dass die Schaltelemente mithilfe einer Auswerte- und Steuereinheit, die als Mikrocontroller ausgebildet ist, überwacht werden.

Aus der EP 1 869 687 B1 ist eine solche Sicherheitsschaltvorrichtung zum sicheren Abschalten eines elektrischen Verbrauchers bekannt. Die bekannte Sicherheitsschaltvorrichtung weist unter anderem zwei in Reihe zueinander angeordnete Wechselschalter auf, die einem Stromversorgungspfad zugeordnet sind, über den ein elektrischer Verbraucher an eine Versorgungsspannung angeschaltet oder von dieser getrennt werden kann. Die Auswerte- und Steuereinheit, die als Mikrocontroller ausgebildet ist, dient dazu, Funktionstests zu definierten Zeitpunkten, insbesondere vor dem Schließen des Stromversorgungspfads zu dem Verbraucher durchzuführen.

Weitere Vorrichtungen zum Überwachen der Funktionsfähigkeit von Wechselschaltern sind aus US 2020/096571 A1, DD 254 074 A1 und DE 199 13 933 bekannt.

Der Erfindung liegt die Aufgabe zugrunde, eine Sicherheitsschaltvorrichtung bereitzustellen, mit der in zuverlässiger und kostengünstiger Weise die Funktionsfähigkeit nicht zwangsgeführter Wechselschalter überwacht werden kann.

Ein Kerngedanke der Erfindung kann darin gesehen werden, eine Sicherheitsschaltvorrichtung zu schaffen, mit der bei Erkennen eines Fehlers insbesondere ein Startvorgang zum Einschalten bzw. Anschalten eines elektrischen Verbrauchers an eine Versorgungsspannung abgebrochen werden kann. Hierzu kann vorzugsweise während eines Startvorgangs die Funktionsfähigkeit von beispielsweise zwei nicht zwangsgeführte Wechselschaltern und insbesondere deren Ruhekontakte ohne Verwendung eines Mikrocontrollers überwacht werden. Die Ruhekontakte, auch Öffnerkontakte genannt, sind jeweils in einem separaten Diagnosekreis angeordnet, wobei die Diagnosekreise bezüglich einer Prüfspannung parallelgeschaltet sind. Die Arbeitskontakte oder Schließerkontakte der Wechselschalter sind in Reihe zueinander in einem Lastromkreis angeordnet. Vorzugsweise wird zur Ansteuerung und Überwachung der Wechselschalter eine Schaltungsanordnung, die vorzugsweise eine Logikschaltung realisiert, eingesetzt, die nur aktive und gegebenenfalls passive diskrete elektrische Bauelemente wie zum Beispiel ohmsche Widerstände, Halbleiterschalter und Kondensatoren aufweist. Angemerkt sei, dass die Wechselschalter beispielsweise als Wechslerrelais ausgebildet sein können.

Das oben genannte technische Problem wird durch die Merkmale des Anspruchs 1 gelöst. Vorteilhafte Weiterbildungen sind Gegenstand der Unteransprüche.

Demgemäß wird eine Sicherheitsschaltvorrichtung zum überwachten Anschalten eines elektrischen und/oder elektronischen Verbrauchers an eine Versorgungsspannung geschaffen. Die Sicherheitsschaltvorrichtung weist einen ersten und zweiten Eingang auf, an die jeweils ein Aktivierungssignal anlegbar bzw. zuführbar ist. Bei dem Aktivierungssignal kann es sich um ein Sensorsignal eines Signalgebers oder zum Beispiel um eine Versorgungsspannung handeln, die zum Bestromen einer Erregerspule dient.

Weiterhin weist die Sicherheitsschaltvorrichtung einen dritten Eingang auf, an den eine Versorgungsspannung zur Energieversorgung des elektrischen und/oder elektronischen Verbrauchers anlegbar oder zuführbar ist. Die Versorgungsspannung kann eine Gleich- oder Wechselspannung sein.

Weiterhin weist die Sicherheitsschaltvorrichtung eine Prüfspannungs-Bereitstellungseinrichtung auf, die vorzugsweise eine Gleichspannung liefert.

Die Sicherheitsschaltvorrichtung weist einen Ausgang auf, an den der elektrische und/oder elektronische Verbraucher anschließbar ist, wobei zwischen dem dritten Eingang und dem Ausgang ein Laststrompfad verläuft.

Bereits an dieser Stelle sei angemerkt, dass auch mehrere Ausgänge zum Anschließen eines mehrphasigen elektrischen Verbrauchers und mehrere dritte Eingänge zum Anlegen einer mehrphasigen Versorgungsspannung vorgesehen sein können, zwischen denen jeweils ein Laststrompfad verläuft. Auf diese Weise kann ein einphasiger oder auch ein mehrphasiger elektrischer Verbraucher an die Sicherheitsschaltvorrichtung angeschlossen werden.

Die Sicherheitsschaltvorrichtung weist ferner einen ersten und zweiten Wechselschalter auf, die jeweils eine Erregerspule, einen Ruhekontakt, einen Arbeitskontakt und einen gemeinsamen Mittelanschluss, der auch als Wurzel bezeichnet wird, aufweisen. Die beiden Wechselschalter können beispielsweise als Wechslerrelais ausgebildet sein.

Der erste Wechselschalter und der zweite Wechselschalter sind mittels der jeweiligen gemeinsamen Mittelanschlüsse elektrisch miteinander verbunden. Auf diese Weise sind die Arbeitskontakte des ersten und zweiten Wechselschalters in dem Laststrompfad in Reihe zueinander angeordnet. Die Erregerspule des ersten Wechselschalters ist in einem ersten Steuerstrompfad, der elektrisch mit dem ersten Eingang verbunden ist, angeordnet, während der Ruhekontakt des ersten Wechselschalters in einem ersten Diagnosestromkreis angeordnet ist. Die Erregerspule des zweiten Wechselschalters ist in einem zweiten Steuerstrompfad, der elektrisch mit dem zweiten Eingang verbunden ist, angeordnet, während der Ruhekontakt des zweiten Wechselschalters in einem zweiten Diagnosestromkreis angeordnet ist. Der erste Diagnosestromkreis und der zweite Diagnosestromkreis sind parallel an der Prüfspannungs-Bereitstellungseinrichtung angeschlossen.

Die Sicherheitsschaltvorrichtung weist ferner eine erste Diagnosestrom-Erfassungseinrichtung auf, die dem ersten Diagnosestromkreis zugeordnet ist bzw. mit diesem in einer Wirkverbindung steht. Sie ist dazu ausgebildet, ein erstes Steuersignal nur dann bereitzustellen, wenn der erste Diagnosestromkreis mittels des Ruhekontakts des ersten Wechselschalters geschlossen ist. Das erste Steuersignal signalisiert somit, dass im ersten Diagnosestromkreis ein Diagnosestrom fließt.

Ferner ist eine zweite Diagnosestrom-Erfassungseinrichtung vorgesehen, sein, die dem zweiten Diagnosestromkreis zugeordnet ist bzw. mit diesem in Wirkverbindung steht. Sie ist dazu ausgebildet ist, ein zweites Steuersignal nur dann bereitzustellen, wenn der zweite Diagnosestromkreis mittels des Ruhekontakts des zweiten Wechselschalters geschlossen ist. Das zweite Steuersignal signalisiert somit, dass im zweiten Diagnosestromkreis ein Diagnosestrom fließt.

Die Sicherheitsschaltvorrichtung weist ferner eine erste ansteuerbare Kurzschlusseinrichtung auf, die elektrisch mit dem zweiten Eingang verbunden ist. Ferner ist eine zweite ansteuerbare Kurzschlusseinrichtung vorgesehen, die elektrisch mit dem ersten Eingang verbunden ist**.** Die erste Kurzschlusseinrichtung ist dazu ausgebildet, unter Ansprechen auf ein erstes, an der zweiten Eingang angelegtes Aktivierungssignal die Erregerspule des ersten Wechselschalters nur dann kurz zu schließen, wenn die zweite Diagnosestrom-Erfassungseinrichtung nach dem Anlegen des ersten Aktivierungssignals das zweite Steuersignal während einer vorbestimmten Zeitdauer bereitstellt. Die zweite Kurzschlusseinrichtung ist dazu ausgebildet, unter Ansprechen auf ein zweites, an den ersten Eingang angelegtes Aktivierungssignal die Erregerspule des zweiten Wechselschalters nur dann kurzzuschließen, wenn die erste Diagnosestrom-Erfassungseinrichtung nach dem Anlegen des zweiten Aktivierungssignals das erste Steuersignal während einer vorbestimmten Zeitdauer bereitstellt.

Dank dieses Mechanismus, startet die Sicherheitsschaltvorrichtung die Überwachung der Wechselschalter mit Beginn des Startvorgangs, also zu dem Zeitpunkt, zu dem an den ersten und zweiten Eingang jeweils ein Aktivierungssignal, z.B. eine Versorgungsspannung angelegt worden sind. Zu beachten ist, dass die Überwachung ohne den Einsatz eines Mikrocontrollers durchgeführt wird.

Vorzugsweise weist die erste und zweite Diagnosestrom-Erfassungseinrichtung jeweils einen Optokoppler auf.

Um eine potenzialfreie Prüfspannung liefern zu können, kann die Prüfspannungs-Bereitstellungseinrichtung einen Übertrager oder Transformator aufweisen, wobei der Übertrager primärseitig mit einem DC/AC-Wandler oder AC/AC-Wandler und sekundärseitig mit einem AC/DC-Wandler verbunden sein kann. Ein DC/AC-Wandler wäre vorzugsweise mit einer externen Gleichspannungsquelle verbunden.

Eine vorteilhafte Ausgestaltung sieht vor, dass die erste Kurzschlusseinrichtung ein Schaltelement zum Kurzschließen der Erregerspule des ersten Wechselschalters und ein RC-Glied mit einer Zeitkonstante aufweist, die die vorbestimmte Zeitdauer festlegt. In ähnlicher Weise kann die zweite Kurzschlusseinrichtung ein Schaltelement zum Kurzschließen der Erregerspule des zweiten Wechselschalters und ein RC-Glied mit einer Zeitkonstante, die die vorbestimmte Zeitdauer festlegt, aufweisen. Die RC-Glieder können beispielsweise jeweils als Tiefpass ausgebildet sein.

Gemäß einer vorteilhaften Weiterbildung kann ein erstes Schaltelement in Reihe mit der Erregerspule des ersten Wechselschalters geschaltet sein, wobei das erste Schaltelement zum Öffnen und Schließen des ersten Steuerstrompfads ausgebildet ist. Ferner kann ein zweites Schaltelement in Reihe mit der Erregerspule des zweiten Wechselschalters geschaltet sein, wobei das zweite Schaltelement zum Öffnen und Schließen des zweiten Steuerstrompfads ausgebildet ist. Ferner kann eine Logikschaltung vorgesehen sein, die dazu ausgebildet sein kann, das erste Schaltelement und das zweite Schaltelement zu schließen, und zwar nur dann, wenn an der Logikschaltung gleichzeitig das erste und zweite Aktivierungssignal, ein Startsignal und das erste und zweite Steuersignal anliegen. In diesem Fall kann die erste Kurzschlusseinrichtung dazu ausgebildet sein, die Erregerspule des ersten Wechselschalters nur dann kurzzuschließen, wenn die zweite Diagnosestrom-Erfassungseinrichtung nach dem Schließen des zweiten Schaltelements das zweite Steuersignal noch während der vorbestimmten Zeitdauer bereitstellt bzw. liefert. Zudem kann die zweite Kurzschlusseinrichtung dazu ausgebildet sein, die Erregerspule des zweiten Wechselschalters nur dann kurzschließen, wenn die erste Diagnosestrom-Erfassungseinrichtung nach dem Schließen des ersten Schaltelements das zweite Steuersignal noch während der vorbestimmten Zeitdauer bereitstellt. Angemerkt sei, dass die Logikschaltung vorzugsweise nur aus aktiven und gegebenenfalls aus passiven diskreten elektrischen Bauelementen, wie zum Beispiel npn- und pnp-Transistoren, elektrischen Widerständen und Kondensatoren, aufgebaut ist.

Dank dieses Mechanismus, startet die Sicherheitsschaltvorrichtung die Überwachung der Wechselschalter mit Beginn des Startvorgangs, also zu dem Zeitpunkt, zu dem ein Startsignal sowie an den ersten und zweiten Eingang jeweils ein Aktivierungssignal, z.B. eine Versorgungsspannung angelegt worden sind.

Gemäß einer vorteilhaften Implementierung beginnt die Überwachung der beiden Wechselschalter zeitversetzt, d.h. zuerst wird die Funktionsfähigkeit des ersten Wechselschalters und anschließend die Funktionsfähigkeit des zweiten Wechselschalters, oder umgekehrt, geprüft. Hierzu kann die Logikschaltung dazu ausgebildet sein, das erste Schaltelement und zeitlich verzögert das zweite Schaltelement, oder umgekehrt, zu schließen. Allerdings kann die Überwachung der beiden Wechselschalter auch gleichzeitig erfolgen.

Zu beachten ist, dass die Überwachung des Einschaltens des elektrischen und/oder elektronischen Verbrauchers ohne den Einsatz eines Mikrocontrollers durchgeführt wird.

Gemäß einer vorteilhaften Weiterbildung kann die erste Kurzschlusseinrichtung ein weiteres Schaltelement aufweisen, das einen ersten Anschluss, der mit dem Ausgang der zweiten Diagnosestrom-Erfassungseinrichtung elektrisch verbunden ist, und einen zweiten Anschluss aufweist, der mit dem zweiten Eingang elektrisch verbindbar ist. Das weitere Schaltelement dient vorzugsweise dazu, die erste Kurzschlusseinrichtung zu aktivieren, falls im ersten Diagnosestromkreis ein Diagnosestrom fließt. Zudem kann die zweite Kurzschlusseinrichtung ein weiteres Schaltelement aufweisen, das einen ersten Anschluss, der mit dem Ausgang des ersten Diagnosestrom-Erfassungseinrichtung elektrisch verbunden ist, und einen zweiten Anschluss aufweist, der mit dem ersten Eingang elektrisch verbindbar ist. Das weitere Schaltelement dient vorzugsweise dazu, die zweite Kurzschlusseinrichtung zu aktivieren, falls im zweiten Diagnosestromkreis ein Diagnosestrom fließt.

Die Erfindung wird nachfolgend anhand von Ausführungsbeispielen in Verbindung mit den beiliegenden Zeichnungen näher erläutert. Darin zeigen:
- Figur 1A: den ersten Teil einer beispielhaften Sicherheitsschaltvorrichtung gemäß der Erfindung, und
- Figur 1B: den zweiten Teil der beispielhaften Sicherheitsschaltvorrichtung gemäß der Erfindung, und
- Figur 2: eine beispielhafte Schaltungsanordnung der in Figur 1B gezeigten Logikschaltung

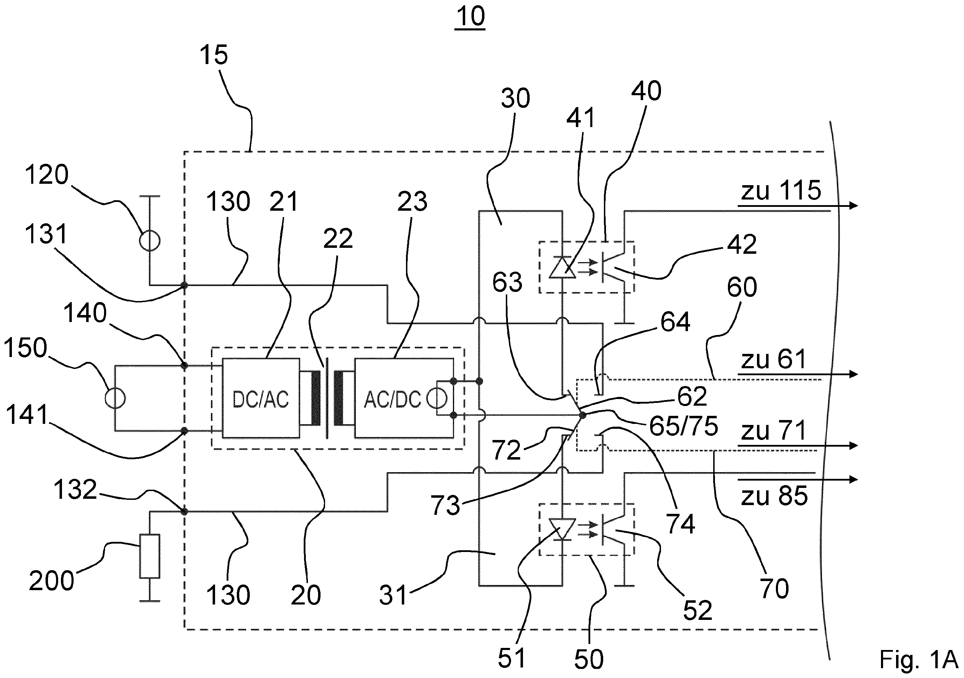

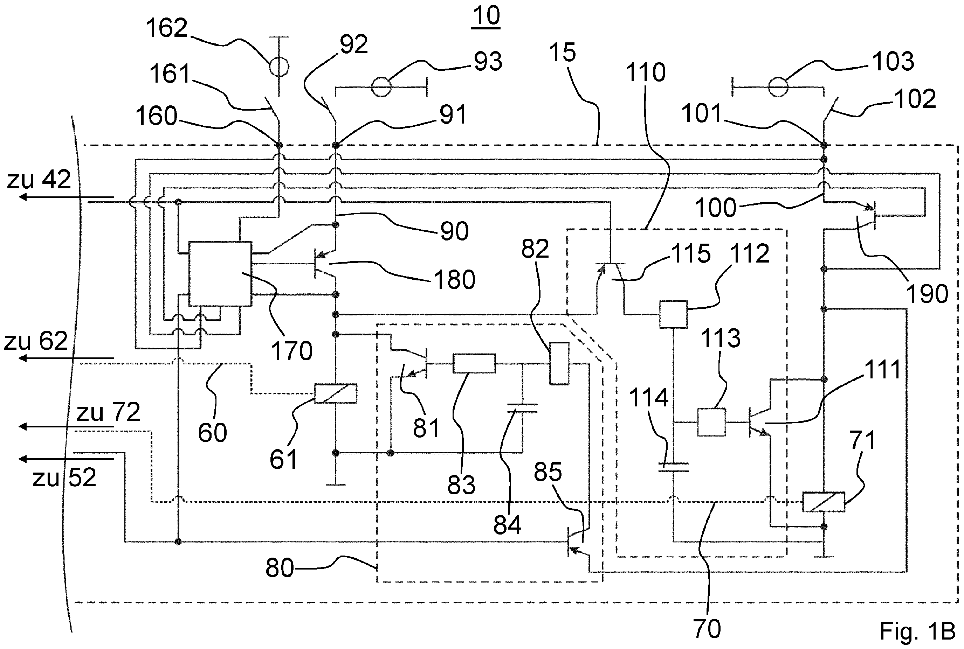

Es wird Bezug genommen auf die Figuren 1A und 1B, die in Zusammenschau eine beispielhafte Sicherheitsschaltvorrichtung 10 zeigen, die beispielsweise in einer industriellen Automatisierungsumgebung, wie zum Beispiel in einem automatisierten Prozesssteuerungssystem eingesetzt werden kann. Die beispielhafte Sicherheitsschaltvorrichtung 10 ist dazu in der Lage, während eines Startvorgangs zum überwachten Einschalten eines elektrischen und/oder elektronische Verbrauchers 200, d.h. vorzugsweise zum überwachten Anschalten eines elektrischen und/oder elektronische Verbrauchers 200 an eine Versorgungsspannung, die Funktionsfähigkeit der Sicherheitsschaltvorrichtung und insbesondere die Funktionsfähigkeit von nicht zwangsgeführten Wechselschaltern zu überwachen und bei Auftritt eines Fehlers den Startvorgang abzubrechen.

Wie in den Figuren 1A und 1B gezeigt, kann die Sicherheitsschaltvorrichtung 10 in einem gestrichelt dargestellten Gehäuse 15 angeordnet sein. Wie weiter in Figur 1B zu sehen, weist die Sicherheitsschaltvorrichtung 10 beispielsweise einen ersten Eingang 91 auf, an den ein Aktivierungssignal beispielsweise bei Betätigung eines Sensors 92 angelegt werden kann. Der Sensor 92 kann zum Beispiel ein Schalter oder Taster sein. Gemäß einer vorteilhaften Implementierung kann an den ersten Eingang 91 eine Spannungsquelle 93 angeschlossen werden. Im vorliegenden Beispiel handelt es sich bei der Spannungsquelle 93 um eine Gleichspannungsquelle, die beispielsweise 24 V bereitstellen kann. Das Aktivierungssignal entspricht in diesem Fall der angelegten Gleichspannung. Weiterhin kann die Sicherheitsschaltvorrichtung 10 einen zweiten Eingang 101 aufweisen, an den ebenfalls ein Aktivierungssignal beispielsweise bei Betätigung eines Sensors 102 angelegt werden kann. Der Sensor 102 kann zum Beispiel ein Schalter oder Taster sein. Gemäß der vorteilhaften Implementierung kann eine Spannungsquelle, beispielsweise eine Gleichspannungsquelle 103 über den Taster 102 an den zweiten Eingang 101 angelegt werden. Das Aktivierungssignal entspricht auch in diesem Fall der angelegten Gleichspannung. Mit anderen Worten: als Aktivierungs- oder Sensorsignal wird somit bei Betätigung der beispielhaften Taster 92 und 102 jeweils eine Gleichspannung dem ersten Eingang 91 und im zweiten Eingang 101 zugeführt.

Wie in Figur 1A gezeigt, kann die Sicherheitsschaltvorrichtung 10 einen dritten Eingang 131 aufweisen, an den eine Versorgungsspannung für die Energieversorgung eines elektrischen und/oder elektronischen Verbrauchers 200 angelegt werden kann. Die Versorgungsspannung wird vorzugsweise über eine Spannungsquelle 120 bereitgestellt, die als Gleichspannungsquelle oder als Wechselspannungsquelle ausgebildet sein kann. Weiterhin weist die Sicherheitsschaltvorrichtung 10 vorzugsweise einen Ausgang 132 auf, an den der elektrische und/oder elektronische Verbraucher 200 angeschlossen werden kann. Wie in Figur 1A zu sehen, verläuft zwischen dem dritten Eingang 131 und dem Ausgang 132 ein Laststrompfad 130. Bereits an dieser Stelle sei darauf hingewiesen, dass auch mehrere dritte Eingänge 131 und mehrere Ausgänge 132 vorgesehen sein können, wenn anstelle eines einphasigen auch ein mehrphasiger elektrischer Verbraucher angeschlossen werden soll. In diesem Fall verläuft zwischen jedem dritten Eingang und jedem Ausgang ein Laststrom pfad.

Die beispielhafte Sicherheitsschaltvorrichtung 10 weist eine Prüfspannungs-Bereitstellungseinrichtung 20 auf, die eingangsseitig über zwei Eingangsanschlüsse 140 und 141 mit einer externen Spannungsquelle verbunden werden kann. Bei der Spannungsquelle 150 kann es sich um eine Wechsel- oder Gleichspannungsquelle handeln. Um eine potenzialfreie Prüfspannung bereitstellen zu können, kann die Prüfspannungs-Bereitstellungseinrichtung 20 einen Übertrager 22 aufweisen, an den primärseitig ein DC/AC-Wandler 21 angeschlossen ist, falls, wie gezeigt, die Spannungsquelle 150 eine Gleichspannungsquelle ist. Andernfalls kann primärseitig ein AC/AC-Wandler angeschlossen werden. Eingangsseitig ist der DC/AC-Wandler 21 an die Eingänge 140 und 141 angeschlossen. Sekundärseitig kann ein AC/DC-Wandler 23 an den Übertrager 22 angeschlossen sein, der ausgangsseitig eine potenzialfreie Gleichspannung als Prüfspannung liefert. Die Gleichspannung ist symbolisch durch eine Gleichspannungsquelle in dem AC/DC-Wandler 23 dargestellt.

Die beispielhafte Sicherheitsschaltvorrichtung 10 weist einen ersten Wechselschalter 60 auf, der eine Erregerspule 61, einen Ruhe- bzw. Öffnerkontakt 63, einen Arbeits- bzw. Schließerkontakt 64, einen gemeinsamen Mitteanschluss 65, der auch als Wurzel bekannt ist, sowie ein bewegliches Schaltglied 62 aufweist. Ferner ist ein zweiter Wechselschalter 70 vorgesehen, der eine Erregerspule 71, einen Ruhe- bzw. Öffnerkontakt 73, einen Arbeits- bzw. Schließerkontakt 74, einen gemeinsamen Mittelanschluss 75, der auch als Wurzel bezeichnet werden kann, und ein bewegliches Schaltglied 72 aufweist. Die beiden Wechselschalter 60, 70 können jeweils als Wechslerrelais ausgebildet sein.

Wie in Figur 1A weiter zu sehen, sind die beiden Wechselschalter 60 und 70 über ihre beiden gemeinsamen Mitteanschlüsse 65 und 75 elektrisch miteinander verbunden. Die Wechselschalter 60 und 70 sind derart verschaltet, dass die Arbeitskontakte 64 und 74 der beiden Wechselschalter 60 und 70 in dem Laststrompfad 130 in Reihe zueinander angeordnet sind. Es ist offensichtlich, dass bei der beispielhaften Sicherheitsschaltvorrichtung 10 der elektrische Verbraucher 200 nur gestartet bzw. an die Spannungsquelle 120 angeschlossen werden kann, wenn der Laststrompfad 130 mittels der beiden Arbeitskontakten 64 und 74 geschlossen ist.

Wie in Figur 1B zu sehen, ist die Erregerspule 61 des ersten Wechselschalter 60 in einem ersten Steuerstrompfad 90, der elektrisch mit dem ersten Eingang 91 verbunden ist, angeordnet, während der Ruhekontakt 63 des ersten Wechselschalters 60 in einem ersten Diagnosestromkreis 30 angeordnet ist, wie in Figur 1 A gezeigt. Die Erregerspule 71 des zweiten Wechselschalters 70 ist, wie Figur 1B zeigt, in einem zweiten Steuerstrompfad 100, der elektrisch mit dem zweiten Eingang 101 verbunden ist, angeordnet, während der Ruhekontakt 73 des zweiten Wechselschalters in einem zweiten Diagnosestromkreis 31 angeordnet ist, wie in Figur 1A zu sehen.

Der erste Diagnosestromkreis 30 und der zweite Diagnosestromkreis 31 sind parallel an der Prüfspannungs-Bereitstellungseinrichtung 20 bzw. an die vom AC/DC-Wandler 23 gelieferten Prüfspannung angeschlossen. Vorzugsweise ist der Pluspol des AC/DC-Wandlers 23 elektrisch mit den beiden Wurzeln 65 und 75 der Wechselschalter 60 und 70 verbunden.

Ferner ist eine erste Diagnosestrom-Erfassungseinrichtung 40 dem ersten Diagnosestrom 30 zugeordnet bzw. steht mit diesem in einer Wirkverbindung. Die Diagnosestrom-Erfassungseinrichtung 40 ist dazu ausgebildet, ein erstes Steuersignal nur dann bereitzustellen, wenn der erste Diagnosestromkreis 30 mittels des Ruhekontakts 63 des ersten Wechselschalters 60 geschlossen ist. Vorzugsweise weist die erste Diagnosestrom-Erfassungseinrichtung 40 einen Optokoppler auf, der aus einer LED 41 oder einer Laserdiode und einem Fototransistor 42 aufgebaut ist. Gemäß der beispielhaften Implementierung ist die LED 41 in dem ersten Diagnosestromkreis 30 angeordnet, wobei die Anode der LED 41 mit dem Ruhekontakt 63 verbunden ist, während die Kathode der LED 41 beispielsweise mit der Masse des AC/DC-Wandlers 23 verbunden ist. Gemäß der beispielhaften Implementierung fließt folglich ein Diagnosestrom durch den ersten Diagnosestromkreis 30, sobald der Ruhekontakt 63, der als Öffner fungiert, geschlossen ist. In diesem Fall emittiert die LED 41 Licht, so dass der Fototransistor 42 leitend wird. Wie in Figur 1A gezeigt, ist ein Anschluss des Fototransistor 42 beispielsweise mit Masse verbunden.

In ähnlicher Weise ist eine zweite Diagnosestrom-Erfassungseinrichtung 50 dem zweiten Diagnosestromkreis 31 zugeordnet bzw. steht mit diesem in Wirkverbindung. Auch die zweite Diagnosestrom-Erfassungseinrichtung 50 kann wiederum einen Optokoppler aufweisen, der eine LED 51 oder eine Laserdiode und einen Fototransistor 52 aufweist. Gemäß der beispielhaften Implementierung ist die LED 51 in dem zweiten Diagnosestromkreis 31 angeordnet, wobei die Anode der LED 51 mit dem Ruhekontakt bzw. dem Öffner 73 des zweiten Wechselschalter 70 verbunden ist, während die Kathode der LED 51 mit dem Masseanschluss des AC/DC-Wandlers 23 verbunden ist. Mit anderen Worten: Die beiden Diagnosekreise 30 und 31 sind parallel an die Ausgangsgleichspannung, d.i. die Prüfspannung, des AC/DC-Wandlers 23 angeschlossen. Gemäß der beispielhaften Implementierung fließt folglich ein Diagnosestrom durch den ersten Diagnosestromkreis 31 sobald der Ruhekontakt 73, der als Öffner fungiert, geschlossen ist. In diesem Fall emittiert die LED 51 Licht, so dass der Fototransistor 52 leitend wird. Wie in Figur 1A gezeigt, ist ein Anschluss des Fototransistor 52 beispielsweise mit Masse verbunden.

Die beispielhafte Sicherheitsschaltvorrichtung 10 weist eine erste ansteuerbare Kurzschlusseinrichtung 80 auf, die in Figur 1B gezeigt ist. Die erste ansteuerbare Kurzschlusseinrichtung 80 ist elektrisch mit dem zweiten Eingang 101 verbunden. Wie später noch näher ausgeführt, befindet sich hierzu beispielsweise ein Schaltelement 190 in dem Steuerstrompfad 100. Ferner ist eine zweite ansteuerbare Kurzschlusseinrichtung 110 vorgesehen, die elektrisch mit dem ersten Eingang 91 verbunden ist. Zu diesem Zweck kann, wie später noch erläutert wird, beispielsweise ein Schaltelement 180 in den ersten Steuerstromkreis 90 geschaltet sein.

Die erste Kurzschlusseinrichtung 80 ist dazu ausgebildet, unter Ansprechen auf ein erstes, an den zweiten Eingang angelegtes Aktivierungssignal die Erregerspule 61 des ersten Wechselschalters 60 nur dann kurz zu schließen, wenn die zweite Diagnosestrom-Erfassungseinrichtung 50 nach dem Anlegen des ersten Aktivierungssignals das zweite Steuersignal während einer vorbestimmten Zeitdauer bereitstellt. Gemäß der vorteilhaften Implementierung handelt es sich bei dem ersten Aktivierungssignal, welches an den Eingang 101 angelegt werden kann, um die von der Spannungsquelle 103 bereitgestellte Gleichspannung.

In ähnlicher Weise ist die zweite Kurzschlusseinrichtung 110 dazu ausgebildet, unter Ansprechen auf ein zweites, an den ersten Eingang 91 angelegtes Aktivierungssignal die Erregerspule 71 des zweiten Wechselschalters 70 nur dann kurzzuschließen, wenn die erste Diagnosestrom-Erfassungseinrichtung 40 nach dem Anlegen des zweiten Aktivierungssignals das erste Steuersignal während einer vorbestimmten Zeitdauer bereitstellt. Das zweite Aktivierungssignal ist gemäß der beispielhaften Implementierung die von der Spannungsquelle 93 bereit gestellte Gleichspannung, die an den Eingang 91 angelegt wird. Angemerkt sei bereits an dieser Stelle, dass es sich bei dem ersten und zweiten Steuersignal der ersten bzw. zweiten Diagnosestrom-Erfassungseinrichtung 40 um ein Steuersignal handelt, welches signalisiert, dass in dem ersten Diagnosestromkreis 30 bzw. in dem zweiten Diagnosestromkreis 31 ein Diagnosestrom fließt. Wie bereits erwähnt, fließt in den jeweiligen Diagnosestromkreisen nur dann ein Diagnosestrom, wenn der Ruhekontakt 63 bzw. der Ruhekontakt 73 geschlossen ist.

Die erste Kurzschlusseinrichtung 80 ist vorteilhafter Weise lediglich mittels diskreter elektrischer Bauelemente aufgebaut. Vorzugsweise weist die erste Kurzschlusseinrichtung 80 ein erstes Schaltelement 81 auf, welches vorzugsweise als npn-Transistor ausgebildet ist. Der Kollektor-Anschluss des Transistor 81 ist mit einem Anschluss der Erregerspule 61 verbunden, während der Emitter-Anschluss des Transistor 81 mit dem zweiten Anschluss der Erregerspule 61 verbunden ist, der wiederum mit Masse verbunden ist. Auf diese Weise ist der Transistor 81 parallel zur Erregerspule 61 geschaltet. Damit der npn-Transistor 81 erst nach der vorbestimmten Zeitdauer leitend wird, ist ein entsprechendes Zeitglied vorgesehen, welches in vorteilhafter Weise als RC-Glied mit einer vorbestimmten Zeitkonstante ausgebildet ist. Die Zeitkonstante legt die vorbestimmte Zeitdauer fest. Das RC-Glied weist vorzugsweise einen elektrischen Widerstand 82 und einen Kondensator 84. Ein Anschluss des elektrischen Widerstand 82 ist hierbei mit einem Anschluss des Kondensators 84 und beispielsweise mit einem Anschluss eines elektrischen Widerstand 83 verbunden, dessen weiterer Anschluss mit dem Basis-Anschluss des Transistor 81 verbunden ist, während ein zweiter Anschluss des Kondensator 84 mit Masse verbunden ist. Wie in Figur 1B zu sehen, ist ein Anschluss der Erregerspule 61 mit dem Emitter-Anschluss des Transistor 81, der wiederum mit Masse verbunden ist. Weiterhin kann die erste Kurzschlusseinrichtung 80 ein weiteres Schaltelement 85, welches beispielsweise wiederum als pnp-Transistor ausgebildet ist, aufweisen. Der Kollektor-Anschluss des Transistors 85 ist mit einem weiteren Anschluss des elektrischen Widerstands 82 verbunden. Der Basis-Anschluss des Transistor 85 ist mit einem weiteren Anschluss des Fototransistors 52 verbunden, wie dies in Zusammenschau der Figuren 1A und 1B ersichtlich wird. Der Emitter-Anschluss des zweiten Transistor 85 ist mit dem zweiten Steuerstrompfad 100 und auf diese Weise mit einem Anschluss der Erregerspule 71 verbunden. Bereits an dieser Stelle sei angemerkt, dass der zweite Anschluss der Erregerspule 71 mit Masse verbunden ist.

Auch die zweite Kurzschlusseinrichtung 110 ist vorteilhafter Weise lediglich mittels diskreter elektrischer Bauelemente aufgebaut. Vorzugsweise weist die zweite Kurzschlusseinrichtung 110 ein erstes Schaltelement 111 auf, welches vorzugsweise als npn-Transistor ausgebildet ist. Der Kollektor-Anschluss des Transistor 111 ist mit einem Anschluss der Erregerspule 71 verbunden, während der Emitter-Anschluss des Transistor 111 mit dem zweiten Anschluss der Erregerspule 71 verbunden ist, der wiederum mit Masse verbunden ist. Auf diese Weise ist der Transistor 111 parallel zur Erregerspule 71 geschaltet. Damit der npn-Transistor 111 erst nach der vorbestimmten Zeitdauer leitend wird, ist ein entsprechendes Zeitglied vorgesehen, welches in vorteilhafter Weise als RC-Glied mit einer vorbestimmten Zeitkonstante ausgebildet ist. Die vorbestimmte Zeitkonstante legt die vorbestimmte Zeitdauer fest. Das RC-Glied weist vorzugsweise einen elektrischen Widerstand 112 und einen Kondensator 114. Ein Anschluss des elektrischen Widerstand 112 ist hierbei mit einem Anschluss des Kondensators 114 und beispielsweise mit einem Anschluss eines elektrischen Widerstand 113 verbunden, dessen weiterer Anschluss mit dem Basis-Anschluss des Transistor 111 verbunden ist, während ein zweiter Anschluss des Kondensator 114 mit Masse verbunden ist. Wie in Figur 1B zu sehen, ist ein Anschluss der Erregerspule 71 mit dem Emitter-Anschluss des Transistor 111, der wiederum mit Masse verbunden ist. Weiterhin kann die zweite Kurzschlusseinrichtung 110 ein weiteres Schaltelement 115, welches beispielsweise wiederum als pnp-Transistor ausgebildet ist, aufweisen. Der Kollektor-Anschluss des Transistors 115 ist mit einem weiteren Anschluss des elektrischen Widerstands 112 verbunden. Der Basis-Anschluss des Transistor 115 ist mit einem weiteren Anschluss des Fototransistors 42 verbunden, wie dies in Zusammenschau der Figuren 1A und 1B ersichtlich wird. Der Emitter-Anschluss des zweiten Transistor 115 ist mit dem ersten Steuerstrompfad 90 und auf diese Weise mit einem Anschluss der Erregerspule 61 verbunden. Bereits an dieser Stelle sei angemerkt, dass der zweite Anschluss der Erregerspule 61 mit Masse verbunden ist.

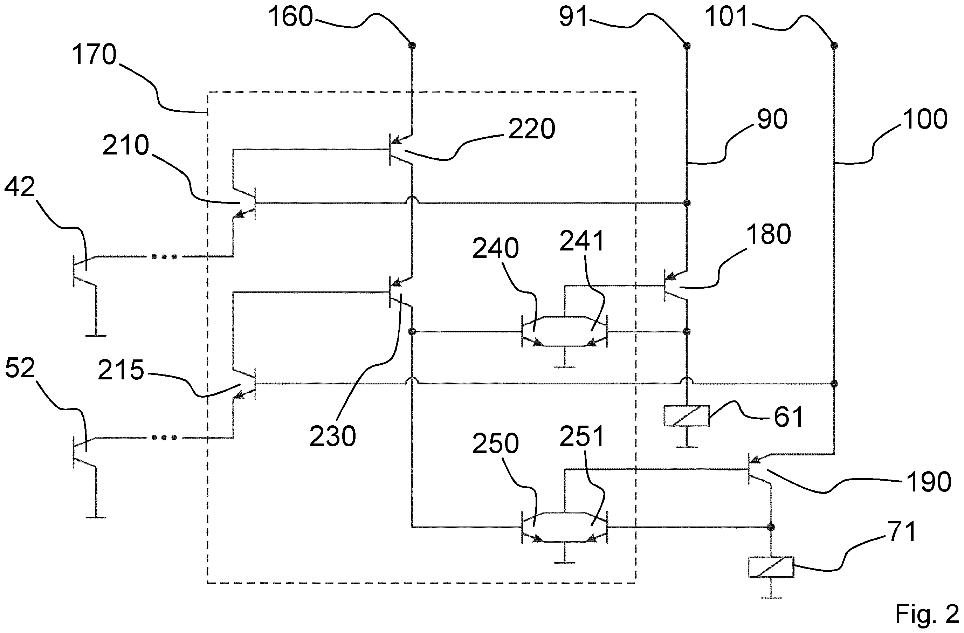

Wie oben erwähnt, kann das Schaltelement 180 in den ersten Steuerstrompfad 90 geschaltet sein. Das Schaltelement 180 ist vorzugsweise als pnp-Transistor ausgebildet, dessen Basis-Anschluss mit einem Ausgang einer Logikschaltung 170, verbunden sein. Eine beispielhafte Implementierung der Logikschaltung 170 ist in Figur 2 gezeigt und wird weiter unten noch näher erläutert. Ein Eingang der Logikschaltung 170 ist elektrisch mit einem Eingang 160 der Sicherheitsschaltvorrichtung 10 verbunden. An den Eingang 160 kann ein Startsignal, z.B. eine Gleichspannung, beispielsweise über einen Schalter 161 angelegt werden. Vorzugsweise kann hierzu eine Gleichspannungsquelle 162 über den Schalter 161 mit dem Eingang 160 verbunden werden. Wie in Figur 1B zu sehen, ist der Emitter-Anschluss des Transistor 180 mit dem ersten Eingang 91 verbunden, während der Kollektor-Anschluss mit einem Anschluss der Erregerspule 61 und somit mit dem Kollektor-Anschluss des Transistors 81 verbunden ist.

Zudem kann, wie bereits oben erwähnt, das Schaltelement 190 in den zweiten Steuerstrompfad 100 geschaltet sein. Das Schaltelement 190 ist vorzugsweise als pnp-Transistor ausgebildet, dessen Basis-Anschluss mit einem weiteren Ausgang der Logikschaltung 170 elektrisch verbunden sein kann. Wie in Figur 1B zu sehen, ist der Emitter-Anschluss des Transistor 190 mit dem zweiten ersten Eingang 101 verbunden, während der Kollektor-Anschluss mit einem Anschluss der Erregerspule 71 und somit mit dem Kollektor-Anschluss des Transistors 111 verbunden ist.

Die beispielhafte Logikschaltung 170 kann, wie in Figur 2 zu sehen, acht Schaltelemente 210, 215, 220, 230, 240, 241, 250 und 251 aufweisen. Die Schaltelemente 210 und 215, 240, 241, 250 und 251 können jeweils als npn-Transistor realisiert sein, während die Schaltelemente 220 und 230 jeweils als pnp-Transistoren realisiert sein können. Die beiden npn-Transistoren 240 und 241 sind beispielsweise derart miteinander verschaltet, dass deren Kollektor-Anschlüsse direkt elektrisch miteinander verbunden und deren Emitter-Anschlüsse direkt miteinander und mit Masse elektrisch verbunden sind. Die beiden npn-Transistoren 250 und 251 sind beispielsweise in gleicher Weise miteinander verschaltet, so dass deren Kollektor-Anschlüsse direkt miteinander elektrisch verbunden sind und deren Emitter-Anschlüsse direkt miteinander und mit Masse elektrisch verbunden sind.

Gemäß einer beispielhaften Implementierung der Logikschaltung 170 ist der Emitter-Anschluss des npn-Transistors 210 mit dem Fototransistor 42 und der Emitter-Anschluss des npn-Transistors 215 mit dem Fototransistor 52 elektrisch verbunden. Der Basis-Anschluss des npn-Transistors 210 ist mit dem Eingang 91 bzw. dem Strompfad 90 elektrisch verbunden, während der Basis-Anschluss des npn-Transistors 215 mit dem Eingang 101 bzw. dem Strompfad 100 elektrisch verbunden ist. Der Kollektor-Anschluss des npn-Transistors 210 ist mit dem Basis-Anschluss des pnp-Transistors 220 elektrisch verbunden, während der Kollektor-Anschluss des npn-Transistors 215 mit dem Basis-Anschluss des pnp-Transistors 230 elektrisch verbunden ist. Die beiden pnp-Transistoren 220 und 230 sind in Reihe geschaltet, wobei der Emitter-Anschluss des pnp-Transistors 220 und somit die Logikschaltung 170 elektrisch mit dem Starteingang 160 verbunden ist.

Der Kollektor-Anschluss des pnp-Transistors 220 ist mit dem Emitter-Anschluss des pnp-Transistors 230 elektrisch verbunden. Der Kollektor-Anschluss des pnp-Transistors 230 kann unmittelbar mit dem Basis-Anschluss des npn-Transistors 240 und dem Basis-Anschluss des npn-Transistors 250 verbunden sein. Die Kollektor-Anschlüsse der npn-Transistoren 240 und 241 können mit dem Basis-Anschluss des pnp-Transistors 180 verbunden sein, während die Kollektor-Anschlüsse der npn-Transistoren 250 und 251 mit dem Basis-Anschluss des pnp-Transistors 190 elektrisch verbunden sein können. Der Basis-Anschluss des npn-Transistors 241 kann mit dem Kollektor-Anschluss des pnp-Transistors 180 elektrisch verbunden sein, während der Basis-Anschluss des npn-Transistors 251 elektrisch mit dem Kollektor-Anschluss des pnp-Transsistors 190 verbunden sein kann. Auf diese Weise wird erreicht, dass während eines Startvorgangs die Funktionsfähigkeit der beiden Wechselschalter 60 und 70 gleichzeitig überwacht wird.

Ist beispielsweise dem Basis-Anschluss des npn-Transistors 250 ein Verzögerungsglied (nicht dargestellt) vorgeschaltet, wird während eines Startvorgangs zuerst die Funktionsfähigkeit des Wechselschalter 70 und anschließend die des Wechselschalters 60 geprüft wird. Angemerkt sei noch einmal, dass ein Startvorgang vorzugsweise das überwachte Einschalten des elektrischen und/oder elektronischen Verbrauchers 200 und insbesondere die Überwachung der Funktionsfähigkeit der Wechselschalter 60 und 70 einleitet.

Die beispielhafte Logikschaltung 170 sorgt dafür, dass der Startvorgang der Sicherheitsschaltvorrichtung 10 und insbesondere die Überwachung der Funktionsfähigkeit der Wechselschalter 60 und 70 erst dann beginnt, wenn die Schalter 92, 102 und 161 geschlossen sind und jeweils ein Steuersignal von den Diagnosestrom-Erfassungseinrichtungen 40 und 50 geliefert wird, welche signalisieren, dass die Öffner-Kontakte 63 und 73 geschlossen sind. Insoweit realisiert die Logikschaltung 170 eine UND-Verknüpfung der Aktivierungssignale an den Eingängen 91 und 101, dem Startsignal am Eingang 160 und den beiden Steuersignalen der Diagnosestrom-Erfassungseinrichtungen 40 und 50. Erst wenn all diese Bedingungen erfüllt sind, beginnt der Startvorgang.

Anzumerken ist noch, dass in den Figuren 1A und 1B symbolisch durch jeweils eine gestrichelte Wirklinie illustriert wird, dass die Erregerspule 71 auf das bewegliche Schaltglied 72 einwirkt, während die Erregerspule 61 auf das bewegliche Schaltglied 62 des Wechselschalters 60 einwirkt.

Nachfolgend wird die Funktionsweise der in den Figuren 1A, 1B und 2 gezeigten beispielhaften Sicherheitsschaltvorrichtung 10 in Verbindung mit einem Startvorgang näher erläutert. Zunächst sei noch angemerkt, dass mit Hilfe der beiden in Reihe geschalteten, nicht zwangsgeführten Wechselschalter 60 und 70 folgende Fehlerfälle erkannt werden können:
1. Ein Verschweißen des jeweiligen Ruhekontakts,
2. ein Verschweißen des jeweiligen Arbeitskontakts,
3. ein Kurzschluss in dem ersten Wechselschalter 60 und in dem zweiten Wechselschalter 70, der durch ein Verschmelzen der jeweiligen Ruhe- und Arbeitskontakte 62, 63, 64 bzw. 72, 73, 74 entsteht, und
4. ein Kurzschluss in der Diagnosestrom-Erfassungseinrichtung 40 bzw. dem Fototransistor 42 und/oder der Diagnosestrom-Erfassungseinrichtung 50 bzw. dem Fototransistor 52.

Gemäß einer vorteilhaften Implementation kann zur Einleitung und Steuerung eines Startvorgangs die in Figur 2 gezeigte beispielhafte Logikschaltung 170 eingesetzt werden. Die Logikschaltung 170 arbeitet vorteilhafterweise wie folgt:
Wenn die beiden Diagnosestrom-Erfassungseinrichtungen 40 und 50 jeweils ein Steuersignal liefern, welches signalisiert, dass der erste Diagnosestromkreis 30 bzw. der zweite Diagnosestromkreis 31 geschlossen ist, und zusätzlich die Schaltelemente 92, 102, 161 geschlossen sind, wird beispielsweise
- der pnp-Transistor 180 in den leitenden Zustand versetzt, wodurch die Prüfung des ersten Wechselschalters 60 (wie oben bereits geschildert) gestartet wird, und
- und gleichzeitig der pnp-Transistor 190 in den leitenden Zustand versetzt, wodurch die Prüfung des zweiten Wechselschalters 70 (wie oben geschildert) gestartet wird.

Wird während der zweistufigen Prüf- bzw. Diagnosephase kein Fehler bezüglich der Wechselschalter 60 und 70 festgestellt, wird der Verbraucher 200 ordnungsgemäß eingeschaltet bzw. mit der Versorgungsspanungsquelle 120 verbunden. Andernfalls wird die Erregerspule des funktionsfähigen Wechselschalters kurzgeschlossen.

Das überwachte Einschalten des elektrischen und/oder elektronischen Verbrauchers 200 wird nachfolgend detaillierter erläutert.

Angenommen sei nunmehr, dass die Sicherheitsschaltvorrichtung 10 gestartet, d. h. der elektrische und/oder elektronische Verbraucher 200 an die Versorgungsspannung, d. h. an die Versorgungsspannungsquelle 120 angeschaltet werden soll. Weiterhin sei angenommen, dass die Taster 92 und 102, welche jeweils als Sensoren oder Meldeeinrichtungen ausgebildet sein können, sich zunächst im geöffneten Zustand befinden. Demzufolge liegt an den Eingängen 91 und 101 keine Versorgungsspannung an und die Erregerspulen 61 und 71 sind nicht bestromt. Ferner sei angenommen, dass sich demzufolge die beiden Ruhekontakte 63 und 73, die als Öffner-Kontakte fungieren, sich im geschlossenen Zustand befinden, sodass sowohl im ersten als auch im zweiten Diagnosestromkreis 30 und 31 ein Diagnosestrom fließt.

Gemäß einem vorteilhaften Szenario sei nunmehr angenommen, dass zur Einleitung des Startvorgangs die beiden Taster 92 und 102 betätigt werden, sodass die von der Spannungsquelle 93 bereitgestellte Versorgungsspannung dem Eingang 91 und die von der Spannungsquelle 103 bereitgestellte Versorgungsspannung dem Eingang 101 zugeführt wird. Weiterhin sei angenommen, dass auch der Schalter 161 geschlossen wird, sodass am Eingang 160 ein Startsignal anliegt, welches im vorliegenden Beispiel von der Gleichspannungsquelle 162 geliefert wird. Dies bedeutet, dass am Kollektor-Anschluss des pnp-Transistors 220 eine Gleichspannung, am Basis-Anschluss des npn-Transistors 210 die von der Spannungsquelle 93 gelieferte Gleichspannung und am Basis-Anschluss des npn-Transistors 215 die von der Spannungsquelle 103 gelieferte Gleichspannung anliegen, so dass die beiden Transistoren 210 und 215 leitend geschaltet sind. Folglich liegt am Basis-Anschluss der pnp-Transistoren 220 und 230 jeweils Massepotential als Steuersignal an, welches über den Fototransistor 42 und npn-Transistor 210 bzw. den Fototransistor 52 und den pnp-Transistor 215 zugeführt wird.

Demzufolge wird die am Eingang 160 als Startsignal anliegende Gleichspannung über die pnp-Transistoren 220 und 230 zunächst an den Basis-Anschluss des npn-Transistors 240 und den Basis-Anschluss des npn-Transistors 250 angelegt. Demzufolge wird über die Transistoren 240 und 241 Massepotenzial an den Basis-Anschluss des pnp-Transistors 180 und über die Transistoren 250 und 251 Massepotential an den Basisanschluss des pnp-Transistors 190 angelegt, so dass die pnp-Transistoren 180 und 190 leitend und die Erregerspule 61 über die Versorgungsspannungsquelle 93 und die Erregerspule 71 über die Versorgungsspannungsquelle 103 bestromt werden. Infolge dessen wird im ordnungsgemäßen Betrieb der Ruhekontakt 63 des Wechselschalters 60 über das bewegliche Schaltglied 62 geöffnet und der Arbeitskontakt 64 geschlossen sowie der Ruhekontakt 73 des Wechselschalters 70 über das bewegliche Schaltglied 72 geöffnet und der Arbeitskontakt 74 geschlossen. Im Ergebnis werden die Diagnosestromkreise 30 und 31 geöffnet und es fließt kein Diagnosestrom mehr, was durch die Diagnosestrom-Erfassungseinrichtung 40 bzw. 50 erfasst wird. Folglich gehen die Fototransistoren 42und 52 in den sperrenden Zustand über. Dies führt ferner dazu, dass der Transistor 115 der zweiten Kurzschlusseinrichtung 110 sperrt, wodurch die Kurzschlusseinrichtung 110 deaktiviert wird. Ebenso sperrt der Transistor 85 der ersten Kurzschlusseinrichtung 80, wodurch die Kurzschlusseinrichtung 80 deaktiviert wird. Bei diesem ordnungsgemäßen Betrieb sind die beiden Arbeitskontakte 64 und 74 geschlossen und somit wird der elektrische Verbraucher 200 ordnungsgemäß an die Versorgungsspannungsquelle 120 angeschlossen.

Angenommen sei nunmehr beispielhaft, dass der Wechselschalter 70 ordnungsgemäß arbeitet und deshalb die Kurzschlusseinrichtung 110 nicht aktiviert wird. Allerdings öffnet der Ruhekontakt 63 nach Schließen der Schalter 161, 102 und 92 fehlerbedingt nicht, so dass im ersten Diagnosestromkreis 30 weiterhin ein Diagnosestrom fließt, der dazu führt, dass der Fototransistor 42 im leitenden Zustand gehalten wird. Als Folge hiervon wird das Massepotenzial über den Fototransistor 42 an den Basis-Anschluss des Transistor 115 der Kurzschlusseinrichtung 110 gelegt, die daraufhin die Kurzschlusseinrichtung 110 aktiviert. Da nunmehr der Transistor 115 leitend ist, wird der durch den Steuerstromkreis 90 fließende Strom über die Kollektor-Emitterstrecke des Transistor 115 in das RC- Glied 112/114 geführt, woraufhin sich der Kondensator 114 auflädt. Bleibt der Ruhekontakt 63 während der durch das RC-Glied 112/114 definierte Zeitdauer geschlossen, lädt sich der Kondensator 114 soweit auf, dass der Transistor 111 nach Ablauf der vorbestimmten Zeitdauer leitend wird und dadurch die Erregerspule 71 kurzschließt, und zwar unabhängig davon, ob der zweite Steuerstrompfad 100 offen oder geschlossen ist. Auf diese Weise wird ein Startvorgang, d. h. das Einschalten bzw. das Anschalten des elektrischen Verbrauchers 200 an die Versorgungsspannung 120 verhindert, da nicht nur der Arbeitskontakt 64 aufgrund eines Verschmelzens des Ruhekontaktes 63 geöffnet bleibt, sondern zusätzlich die Erregerspule 71 des zweiten Wechselschalters 70 kurzgeschlossen wird. In jedem Fall bleibt die Sicherheitsschaltvorrichtung 10 in einem sicheren Zustand selbst dann, wenn der Schalter bzw. die Meldeeinrichtung 102 geschlossen ist, wodurch der zweite Steuerstrompfad 100 über die Versorgungsspannungsquelle 103 mit Energie versorgt wird.

Ein zweiter möglicher Fehler, der mit dieser besonderen Sicherschaltvorrichtung 10 erkannt werden kann, besteht darin, dass ein elektrischer Kurzschluss beispielsweise zwischen dem beweglichen Schaltglied 62, dem Ruhekontakt 63 und dem Arbeitskontakt 64 des ersten Wechselschalters 60 aufgetreten ist. In diesem Fall ist der im Laststromkreis 130 angeordnete Arbeitskontakt 64 bereits geschlossen, auch wenn noch kein Startvorgang eingeleitet worden ist.

Liegt dieser Fehlerfall vor, wird nach dem Schließen der Schalter 92, 102 und 161 die Erregerspule 61 über den Steuerstrompfad 90 bestromt. Allerdings fließt nach wie vor ein Diagnosestrom im ersten Diagnosestromkreis 30, da auch der Ruhekontakt 63 geschlossen bleibt. Dies führt dazu, dass das über den Fototransistor 42 weiterhin bereitgestellte Steuersignal, z.B. das Massepotential, den pnp-Transistor 115 in den leitendenden Zustand versetzt, sodass der im Steuerstromkreis 90 fließende Steuerstrom über den Transistor 115 der Kurzschlusseinrichtung 110 den Kondensator 114 während der vorbestimmten Zeitdauer, die durch die Zeitkonstante des RC-Glieds 112, 114 definiert ist, soweit auflädt, dass der Transistor 111 leitend geschaltet und folglich die Erregerspule 71 kurzgeschlossen wird. Das bedeutet, dass, selbst wenn am Eingang 160 ein Startsignal und am Eingang 102 ein Aktivierungssignal, nämlich die Gleichspannung der Versorgungsspannungsquelle 103 angelegt und somit der zweite Steuerstrompfad 100 geschlossen wird, die Erregerspule 71 nicht bestromt wird, und somit der Arbeitskontakt 74 des zweiten Wechselschalters 70 geöffnet bleibt. Demzufolge bleibt der Laststromkreis 130 geöffnet und somit die Sicherheitsschaltvorrichtung 10 bzw. der Verbraucher 200 in einem sicheren Zustand, obwohl der Wechselschalter 60 durch einen Kurzschluss nicht mehr ordnungsgemäß betrieben werden kann.

In ähnlicher Weise arbeitet die Sicherheitsschaltvorrichtung 10, wenn der Wechselschalter 70 defekt ist und Wechselschalter 60 ordnungsgemäß arbeitet und deshalb die Kurzschlusseinrichtung 80 nicht aktiviert wird.

Da nunmehr der Ruhekontakt 73 nach Schließen der Schalter 161, 102 und 92 fehlerbedingt nicht öffnet, fließt im ersten Diagnosestromkreis 40 weiterhin ein Diagnosestrom, der dazu führt, dass der Fototransistor 52 im leitenden Zustand gehalten wird. Als Folge hiervon wird das Massepotenzial über den Fototransistor 52 an den Basis-Anschluss des Transistor 85 der Kurzschlusseinrichtung 80 gelegt, die daraufhin die Kurzschlusseinrichtung 80 aktiviert. Da nunmehr der Transistor 85 leitend ist, wird der durch den Steuerstromkreis 100 fließende Strom über die Kollektor-Emitterstrecke des Transistor 85 in das RC- Glied 82/84 geführt, woraufhin sich der Kondensator 84 auflädt. Bleibt der Ruhekontakt 73 während der durch das RC-Glied 82/84 definierte Zeitdauer geschlossen, lädt sich der Kondensator 84 soweit auf, dass der Transistor 81 nach Ablauf der vorbestimmten Zeitdauer leitend wird und dadurch die Erregerspule 61 kurzschließt, und zwar unabhängig davon, ob der erste Steuerstrompfad 90 offen oder geschlossen ist. Auf diese Weise wird ein Startvorgang, d. h. das Einschalten bzw. das Anschalten des elektrischen Verbrauchers 200 an die Versorgungsspannung 120 verhindert, da nicht nur der Arbeitskontakt 74 aufgrund eines Verschmelzens des Ruhekontaktes 73 geöffnet bleibt, sondern zusätzlich die Erregerspule 61 des zweiten Wechselschalters 60 kurzgeschlossen wird. In jedem Fall bleibt die Sicherheitsschaltvorrichtung 10 in einem sicheren Zustand selbst dann, wenn der Schalter bzw. die Meldeeinrichtung 92 geschlossen ist, wodurch der erste Steuerstrompfad 90 über die Versorgungsspannungsquelle 93 mit Energie versorgt wird.

## Patentansprüche

1. Sicherheitsschaltvorrichtung (10) insbesondere zum überwachten Einschalten eines elektrischen und/oder elektronischen Verbrauchers (200), aufweisend:
einen ersten Eingang (91) und einen zweiten Eingang (101), an die jeweils ein Aktivierungssignal anlegbar ist,
einen dritten Eingang (131), der zum Anlegen einer Versorgungsspannung zur Energieversorgung des elektrischen Verbrauchers (200) ausgebildet ist,
eine Prüfspannungs-Bereitstellungseinrichtung (20),
einen Ausgang (132), der zum Anschließen des elektrischen Verbrauchers (200) ausgebildet ist, wobei zwischen dem dritten Eingang (131) und dem Ausgang (132) ein Laststrompfad (130) verläuft,
einen ersten und zweiten Wechselschalter (60, 70), die jeweils eine Erregerspule (61, 71), einen Ruhekontakt (63, 73), einen Arbeitskontakt (64, 74) und einen gemeinsamen Mittelanschluss (65, 75) aufweisen, wobei der erste Wechselschalter (60) und der zweite Wechselschalter (70) mittels der jeweiligen gemeinsamen Mittelanschlüsse (65, 75) elektrisch miteinander verbunden sind,
wobei die Arbeitskontakte (64, 74) des ersten und zweiten Wechselschalters (60, 70) in dem Lastrompfad (130) in Reihe zueinander angeordnet sind, wobei die Erregerspule (61) des ersten Wechselschalters (60) in einem ersten Steuerstrompfad (90), der elektrisch mit dem ersten Eingang (91) verbunden ist, und der Ruhekontakt (63) des ersten Wechselschalters (60) in einem ersten Diagnosestromkreis (30) angeordnet ist, wobei
die Erregerspule (71) des zweiten Wechselschalters (70) in einem zweiten Steuerstrompfad (100), der elektrisch mit dem zweiten Eingang (101) verbunden ist, und der Ruhekontakt (73) des zweiten Wechselschalters (70) in einem zweiten Diagnosestromkreis (31) angeordnet ist, wobei der erste Diagnosestromkreis (30) und der zweite Diagnosestromkreis (31) parallel an der Prüfspannungs-Bereitstellungseinrichtung (20) angeschlossen sind, wobei eine erste Diagnosestrom-Erfassungseinrichtung (40) dem ersten Diagnosestromkreis (30) zugeordnet und dazu ausgebildet ist, ein erstes Steuersignal nur dann bereitzustellen, wenn der erste Diagnosestromkreis (30) mittels des Ruhekontakts (63) des ersten Wechselschalters (60) geschlossen ist, wobei
eine zweite Diagnosestrom-Erfassungseinrichtung (50) dem zweiten Diagnosestromkreis (31) zugeordnet und dazu ausgebildet ist, ein zweites Steuersignal nur dann bereitzustellen, wenn der zweite Diagnosestromkreis (31) mittels des Ruhekontakts (73) des zweiten Wechselschalters (70) geschlossen ist, wobei
eine erste ansteuerbare Kurzschlusseinrichtung (80) vorgesehen ist, die elektrisch mit dem zweiten Eingang (101) verbunden ist, wobei
eine zweite ansteuerbare Kurzschlusseinrichtung (110) vorgesehen ist, die elektrisch mit dem ersten Eingang (91) verbunden ist, wobei
die erste Kurzschlusseinrichtung (80) dazu ausgebildet ist, unter Ansprechen auf ein erstes an den zweiten Eingang angelegtes Aktivierungssignal die Erregerspule (61) des ersten Wechselschalters (60) nur dann kurzuschließen, wenn die zweite Diagnosestrom-Erfassungseinrichtung (50) nach dem Anlegen des ersten Aktivierungssignals das zweite Steuersignal während einer vorbestimmten Zeitdauer bereitstellt, und wobei
die zweite Kurzschlusseinrichtung (110) dazu ausgebildet ist, unter Ansprechen auf ein zweites, an den ersten Eingang (91) angelegtes Aktivierungssignal die Erregerspule (71) des zweiten Wechselschalters (70) nur dann kurzuschließen, wenn die erste Diagnosestrom-Erfassungseinrichtung (40) nach dem Anlegen des zweiten Aktivierungssignals das erste Steuersignal während einer vorbestimmten Zeitdauer bereitstellt.

2. Sicherheitsschaltvorrichtung nach Anspruch 1, wobei
die erste und zweite Diagnosestrom-Erfassungseinrichtung (40, 50) jeweils einen Optokoppler (41, 42; 51, 52) aufweist.

3. Sicherheitsschaltvorrichtung nach einem der vorangehenden Ansprüche, wobei die Prüfspannung-Bereitstellungseinrichtung (20) einen Übertrager (22) oder Transformator aufweist.

4. Sicherheitsschaltvorrichtung nach Anspruch 3, wobei
der Übertrager (22) primärseitig mit einem DC/AC-Wandler (21) oder einem AC/AC-Wandler und sekundärseitig mit einem AC/DC-Wandler (23) verbunden ist.

5. Sicherheitsschaltvorrichtung nach einem der vorangehenden Ansprüche, wobei
die erste Kurzschlusseinrichtung (80) ein Schaltelement (81) zum Kurzschließen der Erregerspule (61) des ersten Wechselschalters (60) und ein RC-Glied (82, 84), welches zum Definieren der vorbestimmten Zeitdauer dimensioniert ist, aufweist, und wobei
die zweite Kurzschlusseinrichtung (110) ein Schaltelement (111) zum Kurzschließen der Erregerspule (71) des zweiten Wechselschalters (70) und ein RC-Glied (112, 114), welches zum Definieren der vorbestimmten Zeitdauer dimensioniert ist, aufweist.

6. Sicherheitsschaltvorrichtung nach einem der vorangehenden Ansprüche, ferner aufweisend:
ein erstes Schaltelement (180), das in Reihe mit der Erregerspule (61) des ersten Wechselschalters (60) geschaltet ist, wobei das erste Schaltelement (180) zum Öffnen und Schließen des ersten Steuerstrompfads (90) ausgebildet ist, und
ein zweites Schaltelement (190), das in Reihe mit der Erregerspule (71) des zweiten Wechselschalters (70) geschaltet ist, wobei das zweite Schaltelement (190) zum Öffnen und Schließen des zweiten Steuerstrompfads (100) ausgebildet ist, und
eine Logikschaltung (170), die dazu ausgebildet ist, das erste Schaltelement (180) und das zweite Schaltelement (190) zu schließen, und zwar nur dann, wenn an der Logikschaltung (170) gleichzeitig das erste und zweite Aktivierungssignal, ein Startsignal und das erste und zweite Steuersignal anliegen, wobei
die erste Kurzschlusseinrichtung (80) dazu ausgebildet ist, die Erregerspule (61) des ersten Wechselschalters (60) nur dann kurzuschließen, wenn die zweite Diagnosestrom-Erfassungseinrichtung (50) nach dem Schließen des zweiten Schaltelements (190) das zweite Steuersignal noch während der vorbestimmten Zeitdauer bereitstellt, und wobei
die zweite Kurzschlusseinrichtung (110) dazu ausgebildet ist, die Erregerspule (71) des zweiten Wechselschalters (70) nur dann kurzuschließen, wenn die erste Diagnosestrom-Erfassungseinrichtung (40) nach dem Schließen des ersten Schaltelements (180) das zweite Steuersignal noch während der vorbestimmten Zeitdauer bereitstellt.

7. Sicherheitsschaltvorrichtung nach Anspruch 6, wobei
die Logikschaltung (170) dazu ausgebildet ist, das erste Schaltelement (180) und zeitlich verzögert das zweite Schaltelement (190), oder umgekehrt, zu schließen.

8. Sicherheitsschaltvorrichtung nach Anspruch 6 oder 7, wobei
die erste Kurzschlusseinrichtung (80) ein weiteres Schaltelement (85) aufweist, das einen ersten Anschluss, der mit dem Ausgang der zweiten Diagnosestrom-Erfassungseinrichtung (50) elektrisch verbunden ist, und einen zweiten Anschluss aufweist, der mit dem zweiten Eingang (101) elektrisch verbindbar ist, und wobei
die zweite Kurzschlusseinrichtung (110) ein weiteres Schaltelement (115) aufweist, das einen ersten Anschluss, der mit dem Ausgang der ersten Diagnosestrom-Erfassungseinrichtung (40) elektrisch verbunden ist, und einen zweiten Anschluss aufweist, der mit dem ersten Eingang (101) elektrisch verbindbar ist.

## Claims

1. A safety switching device (10), in particular for switching on an electrical and/or electronic load (200) in a monitored manner, comprising:
a first input (91) and a second input (101), to each of which an activation signal can be applied,
a third input (131), which is designed to apply a supply voltage for supplying power to the electrical load (200),
a test voltage provision device (20),
an output (132), which is designed to connect the electrical load (200), wherein a load current path (130) extends between the third input (131) and the output (132),
a first and second changeover switch (60, 70), each having an energizing coil (61, 71), a normally closed contact (63, 73), a normally open contact (64, 74) and a common center reminal (65, 75), wherein the first changeover switch (60) and the second changeover switch (70) are electrically connected to one another by means of the respective common center terminals (65, 75), the normally open contacts (64, 74) of the first and second changeover switches (60, 70) being arranged in series with one another in the load current path (130),
the energizing coil (61) of the first changeover switch (60) being arranged in a first control current path (90), which is electrically connected to the first input (91), and the normally closed contact (63) of the first changeover switch (60) being arranged in a first diagnostic circuit (30),
the energizing coil (71) of the second changeover switch (70) being arranged in a second control current path (100) which is electrically connected to the second input (101), and the normally closed contact (73) of the second changeover switch (70) being arranged in a second diagnostic circuit (31), the first diagnostic circuit (30) and the second diagnostic circuit (31) being connected in parallel to the test voltage provision device (20), wherein
a first diagnostic current detection device (40) is associated with the first diagnostic circuit (30) and is designed to provide a first control signal only when the first diagnostic circuit (30) is closed by means of the normally closed contact (63) of the first changeover switch (60), wherein
a second diagnostic current detection device (50) is associated with the second diagnostic circuit (31) and is designed to providing a second control signal only when the second diagnostic circuit (31) is closed by means of the normally closed contact (73) of the second changeover switch (70),
a first controllable short-circuiting device (80) being provided, which is electrically connected to the second input (101),
a second controllable short-circuiting device (110) being provided, which is electrically connected to the first input (91),
the first short-circuiting device (80) being designed to short-circuit the energizing coil (61) of the first changeover switch (60) in response to a first activation signal applied to the second input only if the second diagnostic current detection device (50) provides the second control signal for a predetermined period of time after the first activation signal has been applied, and wherein
the second short-circuiting device (110) is designed to short-circuit the energizing coil (71) of the second changeover switch (70) in response to a second activation signal applied to the first input (91) only if the first diagnostic current detection device (40) provides the first control signal for a predetermined period of time after application of the second activation signal.

2. The safety switching device according to claim 1, wherein
each of the first and second diagnostic current detection devices (40, 50) comprises an optocoupler (41, 42; 51, 52).

3. The safety switching device according to one of the preceding claims, wherein the test voltage providing device (20) comprises a transformer (22).

4. The safety switching device according to claim 3, wherein
the transformer (22) is connected on the primary side to a DC/AC converter (21) or an AC/AC converter and on the secondary side to an AC/DC converter (23).

5. The safety switching device according to one of the preceding claims, wherein the first short-circuiting device (80) comprises a switching element (81) for short-circuiting the energizing coil (61) of the first changeover switch (60) and an RC element (82, 84) which is dimensioned for defining the predetermined time period, and wherein
the second short-circuiting device (110) comprises a switching element (111) for short-circuiting the energizing coil (71) of the second changeover switch (70) and an RC element (112, 114) dimensioned for defining the predetermined time duration.

6. The safety switching device according to any one of the preceding claims, further comprising:
a first switching element (180) connected in series with the energizing coil (61) of the first changeover switch (60), the first switching element (180) being adapted to open and close the first control current path (90), and
a second switching element (190) connected in series with the energizing coil (71) of the second changeover switch (70), the second switching element (190) being adapted to open and close the second control current path (100), and
a logic circuit (170) adapted to close the first switching element (180) and the second switching element (190) only when the first and second activation signals, a start signal and the first and second control signals are simultaneously applied to the logic circuit (170), wherein
the first short-circuiting means (80) is adapted to short-circuit the energizing coil (61) of the first changeover switch (60) only when the second diagnostic current detecting means (50) still provides the second control signal during the predetermined period of time after the second switching element (190) has closed, and wherein
the second short-circuiting device (110) is designed to short-circuit the excitation coil (71) of the second changeover switch (70) only when the first diagnostic current detection device (40) still provides the second control signal during the predetermined period of time after the first switching element (180) has closed.

7. The safety switching device according to claim 6, wherein
the logic circuit (170) is designed to close the first switching element (180) and, with a time delay, the second switching element (190), or vice versa.

8. The safety switching device according to claim 6 or 7, wherein
the first short-circuiting device (80) comprises a further switching element (85) having a first terminal electrically connected to the output of the second diagnostic current detecting device (50) and a second terminal electrically connectable to the second input (101), and wherein
the second short-circuiting device (110) has a further switching element (115) which has a first terminal which is electrically connected to the output of the first diagnostic current detection device (40) and a second terminal which can be electrically connected to the first input (101).

## Revendications

1. Dispositif de commutation de sécurité (10) destiné en particulier à la mise sous tension surveillée d'un consommateur (200) électrique et/ou électronique, présentant :
une première entrée (91) et une deuxième entrée (101), sur lesquelles respectivement un signal d'activation peut être appliqué,
une troisième entrée (131), qui est réalisée pour appliquer une tension d'alimentation pour l'alimentation en énergie du consommateur (200) électrique,
un système de fourniture de tension d'essai (20),
une sortie (132), qui est réalisée pour le raccordement du consommateur (200) électrique, dans lequel un trajet de courant de charge (130) s'étend entre la troisième entrée (131) et la sortie (132),
un premier et un deuxième commutateur inverseur (60, 70), qui présentent respectivement une bobine d'excitation (61, 71), un contact de repos (63, 73), un contact de travail (64, 74) et une borne centrale commune (65, 75), dans lequel le premier commutateur inverseur (60) et le deuxième commutateur inverseur (70) sont reliés l'un à l'autre de manière électrique au moyen des bornes centrales communes (65, 75) respectives, dans lequel les contacts de travail (64, 74) du premier et du deuxième commutateur inverseur (60, 70) sont disposés de manière alignée sur le trajet de courant de charge (130), dans lequel la bobine d'excitation (61) du premier commutateur inverseur (60) est disposée sur un premier trajet de courant de commande (90), qui est relié de manière électrique à la première entrée (91), et le contact de repos (63) du premier commutateur inverseur (60) est disposé dans un premier circuit de courant de diagnostic (30), dans lequel
la bobine d'excitation (71) du deuxième commutateur inverseur (70) est disposée sur un deuxième trajet de courant de commande (100), qui est relié de manière électrique à la deuxième entrée (101), et le contact de repos (73) du deuxième commutateur inverseur (70) est disposé dans un deuxième circuit de courant de diagnostic (31), dans lequel le premier circuit de courant de diagnostic (30) et le deuxième circuit de courant de diagnostic (31) sont raccordés de manière parallèle au système de fourniture de tension d'essai (20), dans lequel un premier système de fourniture de courant de diagnostic (40) est associé au premier circuit de courant de diagnostic (30) et est réalisé pour ne fournir un premier signal de commande que lorsque le premier circuit de courant de diagnostic (30) est fermé au moyen du contact de repos (63) du premier commutateur inverseur (60), dans lequel
un deuxième système de détection de courant de diagnostic (50) est associé au deuxième circuit de courant de diagnostic (31) et est réalisé pour ne fournir un deuxième signal de commande que lorsque le deuxième circuit de courant de diagnostic (31) est fermé au moyen du contact de repos (73) du deuxième commutateur inverseur (70), dans lequel
un premier système de court-circuit (80) pouvant être piloté est prévu, qui est relié de manière électrique à la deuxième entrée (101), dans lequel un deuxième système de court-circuit (110) pouvant être piloté est prévu, qui est relié de manière électrique à la première entrée (91), dans lequel le premier système de court-circuit (80) est réalisé pour court-circuiter la bobine d'excitation (61) du premier commutateur inverseur (60) en réponse à un premier signal d'activation appliqué sur la deuxième entrée que lorsque le deuxième système de détection de courant de diagnostic (50) fournit, après l'application du premier signal d'activation, le deuxième signal de commande pendant une durée prédéfinie, et dans lequel
le deuxième système de court-circuit (110) est réalisé pour ne court-circuiter la bobine d'excitation (71) du deuxième commutateur inverseur (70) en réponse à un deuxième signal d'activation appliqué sur la première entrée (91) que lorsque le premier système de détection de courant de diagnostic (40) fournit, après l'application du deuxième signal d'activation, le premier signal de commande pendant une durée prédéfinie.

2. Dispositif de commutation de sécurité selon la revendication 1, dans lequel
le premier et le deuxième système de détection de courant de diagnostic (40, 50) présentent respectivement un coupleur optique (41, 42 ; 51, 52).

3. Dispositif de commutation de sécurité selon l'une quelconque des revendications précédentes, dans lequel le système de fourniture de tension d'essai (20) présente un transmetteur (22) ou un transformateur.

4. Dispositif de commutation de sécurité selon la revendication 3, dans lequel
le transmetteur (22) est relié côté primaire à un convertisseur CC/CA (21) ou à un convertisseur CA/CA et est relié côté secondaire à un convertisseur CA/CC (23).

5. Dispositif de commutation de sécurité selon l'une quelconque des revendications précédentes, dans lequel le premier système de court-circuit (80) présente un élément de commutation (81) pour court-circuiter la bobine d'excitation (61) du premier commutateur inverseur (60) et un organe RC (82, 84), lequel est dimensionné pour définir la durée prédéfinie, et dans lequel
le deuxième système de court-circuit (110) présente un élément de commutation (111) destiné à court-circuiter la bobine d'excitation (71) du deuxième commutateur inverseur (70) et un organe RC (112, 114), lequel est dimensionné pour définir la durée prédéfinie.

6. Dispositif de commutation de sécurité selon l'une quelconque des revendications précédentes, présentant en outre :
un premier élément de commutation (180), qui est commuté en série avec la bobine d'excitation (61) du premier commutateur inverseur (60), dans lequel le premier élément de commutation (180) est réalisé pour ouvrir et fermer le premier trajet de courant de commande (90), et
un deuxième élément de commutation (190), qui est commuté en série avec la bobine d'excitation (71) du deuxième commutateur inverseur (70), dans lequel le deuxième élément de commutation (190) est réalisé pour ouvrir et fermer le deuxième trajet de courant de commande (100), et
un circuit logique (170), qui est réalisé pour fermer le premier élément de commutation (180) et le deuxième élément de commutation (190), et ce seulement lorsque le premier signal et le deuxième signal d'activation, un signal de démarrage et le premier et le deuxième signal de commande sont appliqués simultanément sur le circuit logique (170), dans lequel
le premier système de court-circuit (80) est réalisé pour ne court-circuiter la bobine d'excitation (61) du premier commutateur inverseur (60) que lorsque le deuxième système de détection de courant de diagnostic (50) fournit le deuxième signal de commande encore pendant la durée prédéfinie après la fermeture du deuxième élément de commutation (190), et dans lequel
le deuxième système de court-circuit (110) est réalisé pour ne court-circuiter la bobine d'excitation (71) du deuxième commutateur inverseur (70) que lorsque le premier système de détection de courant de diagnostic (40) fournit le deuxième signal de commande encore pendant la durée prédéfinie après la fermeture du premier élément de commutation (180).

7. Dispositif de commutation de sécurité selon la revendication 6, dans lequel
le circuit logique (170) est réalisé pour fermer le premier élément de commutation (180) et, de manière décalée dans le temps, le deuxième élément de commutation (190), ou inversement.

8. Dispositif de commutation de sécurité selon la revendication 6 ou 7, dans lequel
le premier système de court-circuit (80) présente un autre élément de commutation (85), qui présente une première borne, qui est reliée de manière électrique à la sortie du deuxième système de détection de courant de diagnostic (50), et une deuxième borne, qui peut être reliée de manière électrique à la deuxième entrée (101), et dans lequel
le deuxième système de court-circuit (110) présente un autre élément de commutation (115), qui présente une première borne, qui est reliée de manière électrique à la sortie du premier système de détection de courant de diagnostic (40), et une deuxième borne, qui peut être reliée de manière électrique à la première entrée (101).
